# EUROPEAN PATENT APPLICATION

(11) **EP 1 853 096 A2**
(43) Date of publication of application: **07.11.2007**
(21) Application number: 06255156.9
(22) Date of filing: 05.10.2006
(51) Int. Cl.: H05K 3/20, F21S 8/00

(54) **Metal carrier for leds in lamp assembly**

(30) Priority: 03.05.2006 US 416700
(71) Applicant: Grote Industries, Inc., Madison, Indiana 47250 (US)
(72) Inventor: Brandt, Bruce B., Bedford, Kentucky 40006 (US); Branstetter, Cary D., Madison, Indiana 47250 (US); Brooks, Timothy W., Madison, Indiana 47250 (US); Bode, Shane Elizabeth, Smyrna, Georgia 30080 (US)
(74) Representative: Tomkinson, Alexandra

(57) **Abstract**

Novel arrangements are disclosed that provide for replacement of printed circuit boards useful in regulating current for LEDs. In one embodiment, a conductive track is disclosed that forms a pattern for placement of electrical components. The track can be made out of any suitably conductive material and may be stamped, cut, or formed depending on the material type. The conductive track can conduct both electricity and heat. Portions of the conductive track can be removed creating a gap. Electrical components can be placed along the conductive track spanning the gap to create a circuit path. Other embodiments include wiring harnesses that contain embedded electrical components. The harnesses may occupy less space than some embodiments of the conductive track. An electrical connector may be provided to allow easy replacement of the LED.

## Description

### FIELD OF THE INVENTION

The present invention resides generally in the field of illumination, and in a particular aspect relates to systems useful in LED illumination.

### BACKGROUND

Light emitting diodes (LEDs) are becoming lighting devices of choice, useful in a range of applications, some of which include replacements for incandescent lamps. The popularity of LEDs in some fields is driven in part by the relatively long life of LEDs and the reduction in power required to produce light comparable to incandescent lighting systems. This reduction in power is particularly attractive in a number of different technological fields that look to reduce power consumption of larger electrical systems or alternatively utilize the excess for other electrical devices. As an example of one field that is increasingly turning to LED lighting systems, the automotive industry has begun exploring, and in some cases actually using LEDs as replacements for incandescent lamps.

LEDs are made from semiconductor materials and have the property of producing light upon excitation by an electric current. In addition to producing light, LEDs also produce heat that if not properly dissipated may subject the LED to high operating temperatures. High operating temperatures reduce the efficiency of the LED to produce light and may also reduce the effective life of the LED. Generally speaking, higher current generates more light output and higher heat. At a point, the higher current levels will reduce the efficiency of the LED thus producing more heat and less light. Heat sinks can be used in some devices to extract heat from the LED thus lowering the operating temperature. The lower operating temperature, in turn, encourages a higher level of efficiency of the LED to produce light and possibly also preserves the effective life of the LED.

Because LEDs may generate more heat as more light is driven at high current levels, LEDs are sometimes coupled to driving circuits to regulate the current to a desired level. The driving circuitry can be composed of many different types of electrical components and are often mounted on printed circuit boards (PCB).

Printed circuit boards, unfortunately, can be the highest cost component in LED lamp assemblies. Furthermore, PCBs can occupy valuable space that could otherwise be used for other desirable purposes.

Because of this, it can sometimes be difficult to lower the cost of an LED lamp to a point where it can be a viable replacement for incandescent lamps.

In view of this background, the need remains for improved systems for LED lighting devices. The present invention is addressed to these needs.

### SUMMARY

Accordingly, in certain aspects, disclosed embodiments provide novel arrangements for illuminating mobile vehicles. The novel arrangements involve the use of light emitting diodes that rely on drive components that need not be mounted to a printed circuit board.

Accordingly, in one aspect, certain embodiments provide an electrical circuit comprising a unsupported conductor having at least one gap formed therein and an electrical component having a first lead and a second lead, the first and second leads being conductively coupled to the unsupported conductor such that the electrical component bridges the gap.

In another aspect, certain embodiments provide an electrical circuit comprising an unsupported conductor having a first portion and a second portion and at least one electrical component. Each of said at least one electrical components have a first lead and a second lead, the first lead being conductively coupled to the first portion and the second lead being conductively coupled to the second portion wherein the first portion and the second portion are coupled only by said at least one electrical component and wherein at least one electrical component forms a structural member of said unsupported conductor.

In another aspect, certain embodiments provide a conductive device kit comprising at least one electrical component and an unsupported conductor, the unsupported conductor having at least a portion adapted to be removed thereby forming a gap. The unsupported conductor is configured to receive at least one electrical component across the gap thereby forming a circuit path.

In a further aspect, certain embodiments provide a method of making a conductive device, the method comprising providing an operative piece, shaping the operative piece into an unsupported conductor, forming a gap in the unsupported conductor and placing an electrical component across the gap thereby forming a circuit path.

In still another aspect, certain embodiments provide a method of making a conductive device, the method comprising providing an unsupported conductor, forming a gap, and placing an electrical component across the gap thereby forming a circuit path.

In still another aspect, certain embodiments provide a method of retrofitting a lighting device, the method comprising providing a lamp assembly, removing an existing lighting source from the lamp assembly, providing an unsupported conductor having electrical components forming a circuit, and placing the unsupported conductor into the cradle.

In still another aspect, certain embodiments provide a wiring assembly embedded with a circuit, the assembly comprising an unsupported conductor having a first wire section and a second wire section with a gap therebetween, an electrical component having a first component end and a second component end, the electrical component coupling the first and second wire sections across the gap, and a light emitting diode operatively coupled to the unsupported conductor.

In another aspect, certain embodiments provide a wiring assembly embedded with a circuit, the assembly comprising an unsupported conductor having a first wire section and a second wire section with a gap therebetween, an electrical component having a first component end and a second component end, the electrical component coupling the first and second wire sections across the gap, a connector operatively coupled to the first end; and a light emitting diode selectively operatively coupled to the connector.

The disclosed embodiments provide LED lighting systems that need not rely on printed circuit boards for useful placement of electrical drive components. Additional embodiments as well as features and advantages of the invention will be apparent from the further descriptions herein.

### BRIEF DESCRIPTION OF THE DRAWINGS

Although the characteristic features of this invention will be particularly pointed out in the claims, the invention itself, and the manner in which it may be made and used, may be better understood by referring to the following description taken in connection with the accompanying figures forming a part thereof.
FIG. 1 is a perspective view of one embodiment of a carrier.
FIG. 2 is a perspective view of one embodiment of a carrier with electronic components.
FIG. 3 is a perspective view of the carrier with electronic components of FIG. 2 after further processing.
FIG. 4 is a perspective view of another embodiment of a carrier with electronic components.
FIG. 5 is a perspective view of one embodiment of a lamp.
FIG. 6 is a perspective view of another embodiment of a lamp.
FIG. 7 is a perspective view of one embodiment of a lamp assembly.
FIG. 8 is a perspective view of one embodiment of a lamp assembly.

### DETAILED DESCRIPTION

For the purposes of promoting an understanding of the principles of the invention, reference will now be made to the embodiments illustrated in the drawings and specific language will be used to describe the same. It will nevertheless be understood that no limitation of the scope of the invention is thereby intended, and alterations and modifications in the illustrated devices, and further applications of the principles of the invention as illustrated therein are herein contemplated as would normally occur to one skilled in the art to which the invention relates.

As described above, certain embodiments of the present invention provide novel arrangements for illuminating mobile vehicles. As used herein, the term "mobile vehicles" includes, but is not limited to, passenger cars, trucks, buses, tractors, trailers, heavy equipment, marine craft, aircraft, etc. Also as used herein, the term "light emitting diode," or "LED," refers to diodes that can be made of materials such as, but not limited to, GaAs, GaAlAs, GaAsP on a GaAs substrate, GaP, GaAlAsP, GaAsP on GaP substrate, InGaAIP, 2-chip yellow GaP, GaAlP, GaP, and InGaN. Also as used herein, the term "light" refers to electromagnetic radiation in general whether or not the radiation is at a wavelength visible to the human eye.

By way of explanation only, a printed circuit board (PCB) can sometimes be thought of as composed of conductive tracks supported by a non-conductive board. The board provides, among other things, a platform for support of the conductive tracks. Some materials useful for the board are FR4 and CEM1. The conductive tracks found on PCBs can be superimposed on the board through a combination of lamination, etching, and/or electroplating processes, among others. The conductive tracks form the electrical connections required to communicate current between components. The embodiments of the present invention, however, eliminate the non-conductive board and instead rely solely on the conductive tracks for both electrical connectivity and structural support. In the embodiments of the present invention the above described tracks can be referred to as unsupported conductors. In some embodiments the unsupported conductors disclosed herein can be formed using methods other than lamination, etching and/or electroplating. For example, the unsupported conductors can be stamped, formed or cut. In other embodiments the unsupported conductors can be composed of wire leads between electrical components. Still other types of unsupported conductors are contemplated. The unsupported conductors can be made from any electrically conductive metal or alloy, where copper is but one example.

It will be appreciated that many electrically conductive materials are also useful in conducting heat. It would be beneficial in some applications, therefore, to use unsupported conductors having larger dimensions than those typically found on PCBs such that the tracks consist of more material useful in conducting heat away from certain electrical components. By way of example only, in some embodiments the unsupported conductor could be made of copper for conducting electric current and also for conducting heat away from heat generating electrical components such as LEDs.

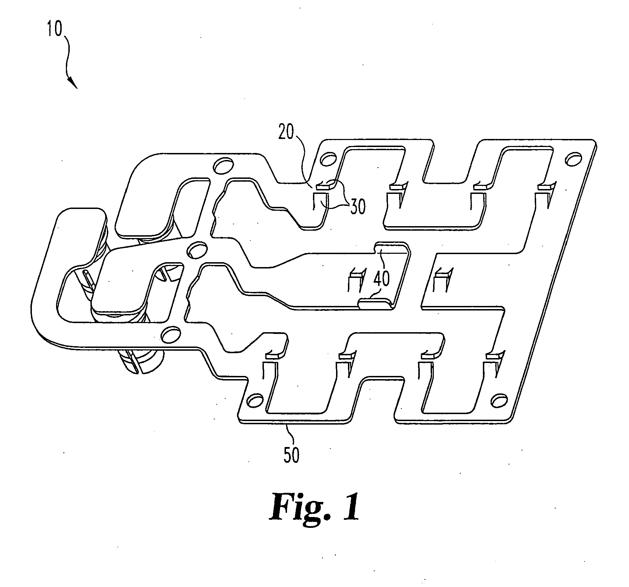

Turning now to FIG. 1, unsupported conductor 10 is shown prior to installation of an LED and associated electrical components. Unsupported conductor 10 can be shaped, for example, by stamping, cutting, or forming conductive material. Unsupported conductor 10 can be formed in a general shape required for installation interior to a lighting system. In one embodiment, the outer dimensions, thickness, and elevation changes of unsupported conductor 10 can be formed to accommodate installation in a headlamp assembly for a mobile vehicle.

Unsupported conductor 10 can have connectors 20 formed by snipping the metal frame and bending tabs 30 out of the plane of unsupported conductor 10. Connectors 20 are formed to receive electrical components associated with the LED and in that regard can take on a variety of forms not shown in the embodiment of FIG. 1. For example, connectors 20 can be raised or bent in the direction shown in FIG. 1 by crimping the edge of unsupported conductor 10 rather than snipping, or can be dimpled into unsupported conductor 10 thereby forming a mounded surface. It is also possible to form connectors 20 by depressing the metal of unsupported conductor 10 into shallows or dimples away from the direction shown in FIG. 1. Connectors 20 can also be configured to allow the electrical component to be snap fit to unsupported conductor 10 such as through a crimp tab. Unsupported conductor 10 can also be formed to contain holes through which the lead of an electrical component may pass. Alternatively, connectors 20 need not be present on some embodiments so long as sufficient space exists on unsupported conductor 10 to accommodate the electrical component sought to be mounted.

Fences 40 can be formed in unsupported conductor 10 to constrain the movement of some electrical components such as an LED. In the pre-installed configuration shown in FIG. 1, tabs 50 can provide structural support to unsupported conductor 10.

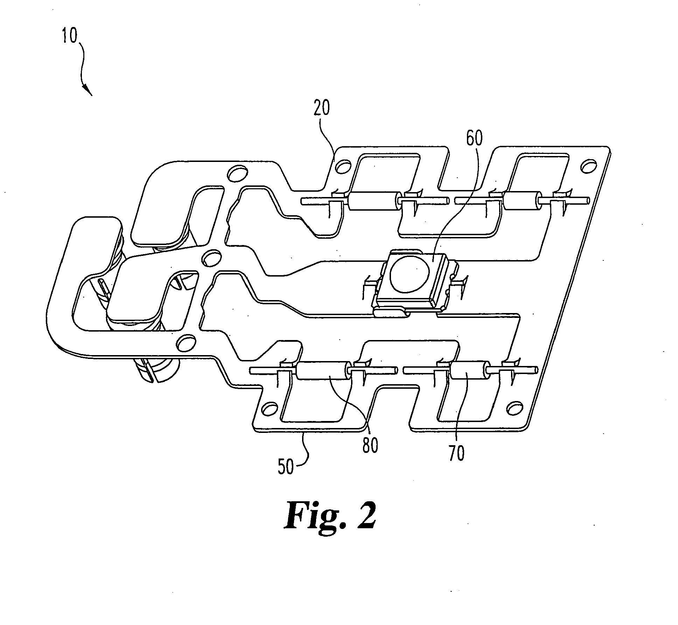

FIG. 2 shows unsupported conductor 10 after installation of LED 60 and associated electrical components 70 and 80. Though electrical components 70 and 80 are shown attached to connectors 20 that have been formed using the arrangement described previously, it will be understood that other connection methods can also be used as described above. Any leaded electronic components (resistors, diodes, etc.) can be secured to unsupported conductor 10 by, for example, resistance welding. Surface mount components such as LEDs, resistors, diodes, etc., can be secured using non-contact soldering techniques such as reflow, laser, or hot air. In the composition of unsupported conductor 10 and its configuration shown in FIG. 2 it will be understood that the unsupported conductor should be further processed to remove or otherwise sever tabs 50 prior to use of the electrical device.

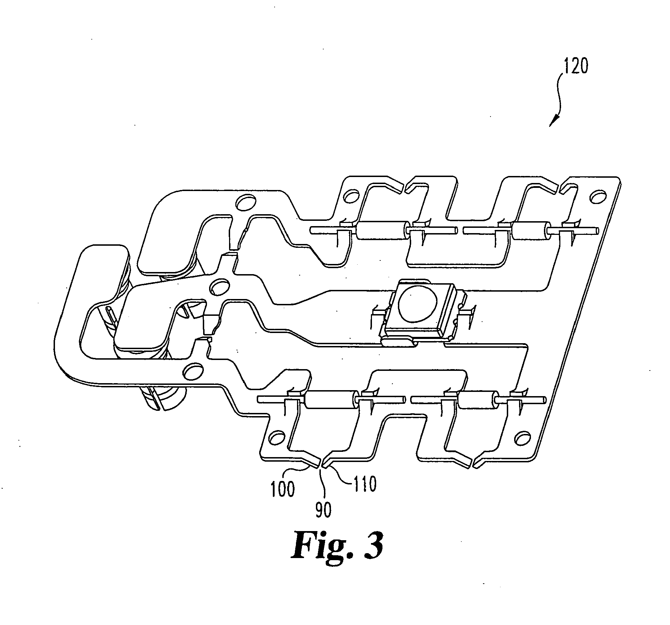

FIG. 3 shows the configuration of unsupported conductor 10 populated with electrical devices and further processed from the embodiment disclosed in FIG. 2. Tabs 50 previously shown in FIGS. 1 and 2 are shown in FIG. 3 as severed and bent forming gaps 90 and bent pieces 100 and 110. Tabs 50 have been severed in a manner described above so as to eliminate the conductive path through tabs 50 and instead provide a conductive path through electrical components 70 and 80. Other techniques can be used to sever and bend tab 50, such as a single stamping motion like crimping. The particular technique chosen for any individual application may depend on the tooling available. Gap 90 can be formed to prevent arcing between bent pieces 100 and 110 depending on operating conditions such as voltage levels and atmospheric conditions. The configuration shown in FIG. 3 can be referred to as unsupported conductor 120. Unsupported conductor 120 can conduct electricity through electrical components 70 and 80 thereby forming an electric circuit, and can also conduct heat away from LED 60 as described above. Other manufacturing techniques can be used to sever tabs 50 such as, but not limited to, cutting tabs 50 completely from carrier 10.

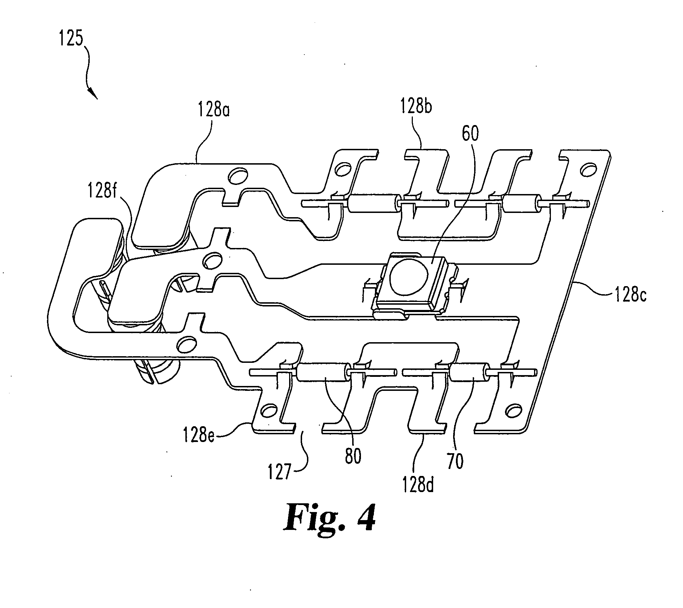

FIG. 4 shows another embodiment of an unsupported conductor populated with electrical components. Components 70 and 80 along with LED 60 are shown mounted to unsupported conductor 125. Unsupported conductor 125 is similar in many respects to unsupported conductor 120 in FIG. 3, with the exception that the tabs have been removed completely as can be seen by gap 127. Gap 127 can be created by snipping both ends of the tab, or alternatively can be created with a single stamping motion. Other methods can also be used to remove the tab.

After tabs 50 have been removed from the unsupported conductor, circuit paths are formed between electrical components through segments 128a, 128b, 128c, 128d, 128e and 128f of the unsupported conductor. The segments serve as conduits for electrical communication between and among the electrical components and the power supply.

An unsupported conductor as described above may be useful in many applications and can offer cost savings compared to printed circuit boards. The unsupported conductor can be manufactured cheaply by simply stamping a shape into stock metal sheet as compared to the relatively complex procedure of laminating, etching and/or electroplating required for some PCBs. The relative expense of producing the unsupported conductor may also lead to cost savings if replacement of the unsupported conductor becomes necessary.

Because some applications contemplate using the unsupported conductor as described above as replacements for incandescent lamp bulbs, the unsupported conductor can be used as retrofit kits useful for manufacturers, retailers, mechanics, and consumers. Many other uses are contemplated for the unsupported conductor.

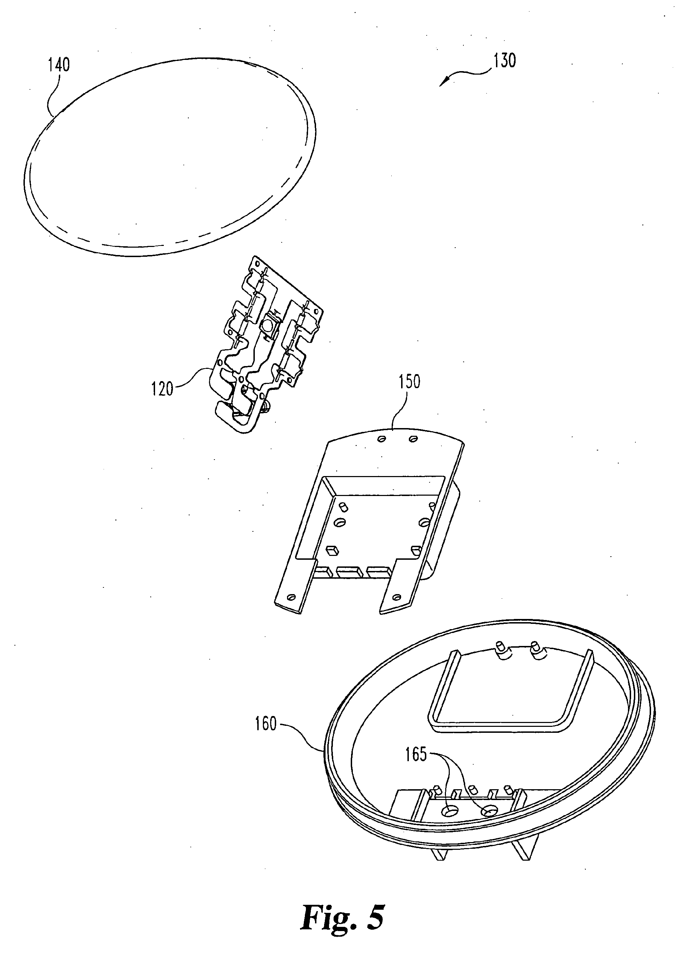

Turning now to FIG. 5, lamp assembly 130 is depicted as composed of lens 140, unsupported conductor 120, cradle 150 and socket base 165. In the illustrated embodiment, unsupported conductor 120 is configured to be received by cradle 150 in a manner reminiscent of U.S. Patent Application 10/920,796 to William Dominic Grote III titled "Conversion Cradle Incandescent Lamp to LED Lamp." Cradle 150 can be configured to contain electrical components, circuit boards, or other accessories apart from unsupported conductor 120. Cradle 150 is adapted to be received by socket base 165 such that it provides a platform to mount unsupported conductor 120 within the socket base. The design of the cradle shown in the embodiment of FIG. 5 provides a mechanism through which an LED assembly can be used in an existing incandescent bulb lamp assembly. Sockets 165 are adapted to receive terminals formed in unsupported conductor 120, thus providing power to light the LED. It will be understood, however, that lamp assembly 130 may not only be useful as a retrofit kit, but may also be originally designed for use with LED lighting systems.

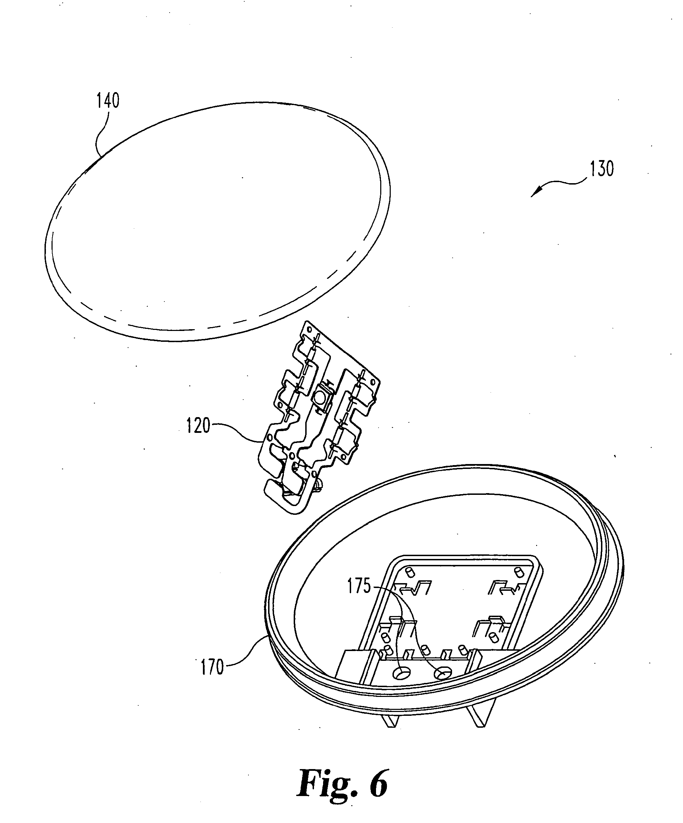

FIG. 6 depicts a housing 170 tooled to accommodate unsupported conductor 120 without the need for the cradle as depicted in FIG. 5. Dispensing with the need for a cradle may reduce the cost of manufacture which may be attractive to some businesses. The lamp system shown in FIG. 6 can also be used as a retrofit to existing lamp systems whereby the entire lamp system is replaced as opposed to just the bulb as depicted in FIG. 5. Similar to the embodiment shown in FIG. 5, unsupported conductor 120 contains terminals that can be received by sockets 175 contained in socket base 170. After unsupported conductor 120 is mated to sockets 175 in socket base 170, lens 140 can be fitted to socket base 170 to complete the lamp assembly.

Other cost and space savings can be realized in some applications by replacing the segments of the processed unsupported conductor as described above with lead wires. In some embodiments, electrical components can be connected to lead wires creating wiring harnesses that contain circuits useful in driving LEDs. A circuit configured in this way may occupy a smaller area than the processed unsupported conductor described above and therefore may be used in some applications requiring tight fits. As mentioned above, in some embodiments of the present invention the lead wires can be referred to as unsupported conductors.

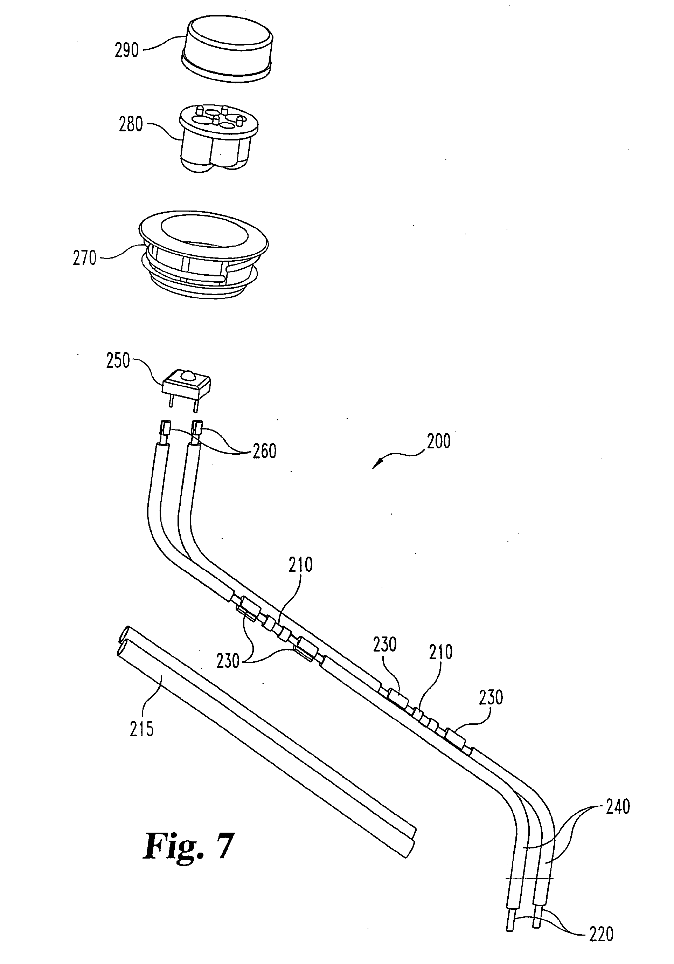

Turning now to FIG. 7, a wiring harness is shown generally at 200. Harness 200 has incorporated a number of electrical components 210 which are attached to unsupported conductors 220 through crimps 230. Crimps 230 can be used to eliminate the need to solder the components 210 to unsupported conductors 220 thus protecting harness 200 and components 210 from exposure to high levels of heat which may damage or degrade the performance of some types of components. Components 210 may include resistors, capacitors, and diodes, among others. In some applications, however, it may be appropriate to solder the electrical components to the unsupported conductors. Other methods of attachment are also contemplated such as, but not limited to, ultrasonic welding.

Electrical components 210 can be protected from the environment, moisture and corrosion using protector 215. Protector 215 includes, but is not limited to, heat shrink tubing, over-molded protective members, and cable seals.

Unsupported conductors 220 can serve as a heat sink to reduce the operating temperature of the LED. Unsupported conductors 220 can furthermore be protected by insulation 240. In some applications, insulation 240 can be appropriately selected and/or designed to accept heat generated by LED 250 and dissipate heat down the length of unsupported conductors 220.

LED 250 is attached to the harness 200 through LED crimps 260. Other attachment methods are also contemplated, such as, but not limited to, electrical connectors, soldering, ultrasonic welding, etc.

Grommet 270 is shown prior to receiving housing 280. Housing 280 is adapted to receive LED 250 and wiring harness 200. Lens 290 covers housing 280 and is furthermore adapted to be received within grommet 270 to form a lamp assembly. The shape of the lamp is depicted as circular in FIG. 7, but may also be oval, rectangular or other types as may be desirable depending on the application.

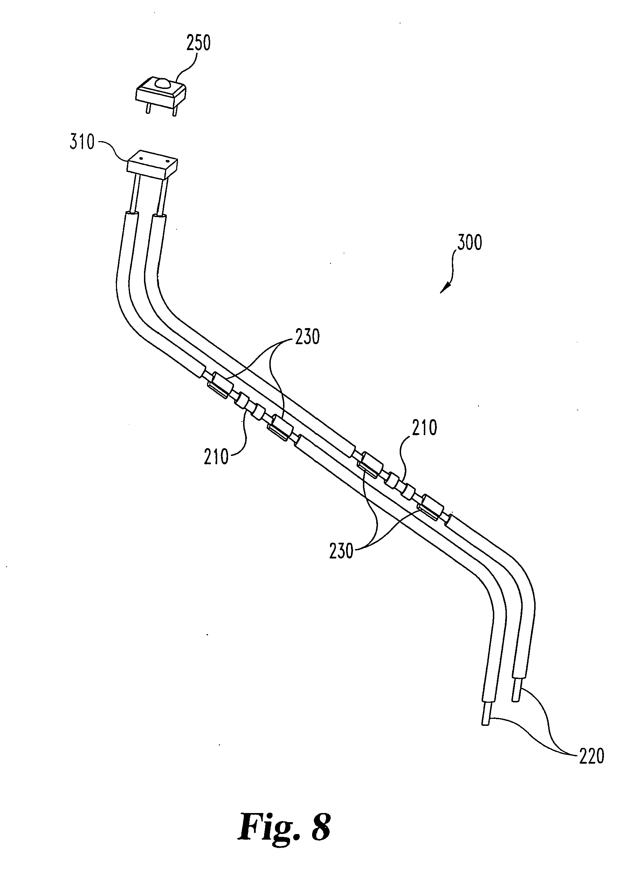

FIG. 8 depicts a wiring harness 300 having an electrical connector 310. Electrical connector 310 is capable of receiving LED 250 such that LED 250 can be easily replaced should the need arise. An electrical connector provided as described in this embodiment may permit replacement of LED 250 without the need to replace wiring harness 200. Similar to the embodiment shown in FIG. 7, harness 300 has incorporated a number of electrical components 210 which are attached to unsupported conductors 220 through crimps 230.

In some applications, electrical circuits contained in wiring harnesses as described above can be contained in smaller spaces than circuits created from conductive tracks as described above. Wiring harnesses described herein permit mounting in relatively small spaces such as, but not limited to, the rear upper header rail of trailers. Trailer manufacturers may sometimes decrease the space available in the rear upper header rail in an effort to gain more interior storage space. Such space can sometimes be small enough that some lighting devices and their methods of attachment may not be suitable. For example, small spaces may sometimes prohibit the use of rubber grommets as mounting devices depending on the type of lighting device used. Some embodiments of the invention described above may be well suited for the reduced spaces available in the rear upper header rail. The size of the wiring harness in some embodiments may be small enough to fit in the reduced space available in the rear upper header rail. In other embodiments, the relatively small size of the wiring harness and LED combination may allow the use of rubber grommets as mounting devices.

In another embodiment, a surface mounted version of the wiring harness and LED can be used wherein the wiring harness described above runs in the upper header rail from lamp to lamp creating a driving circuit useful in powering multiple LEDs.

Many embodiments of the present invention are contemplated and are not limited to a single lamp or function or shape of the lamp. Certain embodiments can be used in many types of lamps including, but not limited to, automotive lamps such as stop lamps, turn signal lamps, tail lamps, license lamps, identification lamps, clearance lamps, dome lamps, side marker lamps, headlamps, parking lamps, and cornering lamps, just to name a few.

It will be understood by those skilled in the art that the unsupported conductors can be packaged as part of kits sold and/or marketed in retail outlets, wholesale outlets, as well as sold and/or marketed over the phone, television, internet, or any other remote types of marketing and sales. It will also be understood that the unsupported conductors can be used to retrofit existing vehicles, or can be installed as kits onto newly manufactured vehicles.

While the invention has been illustrated and described in detail in the drawings and foregoing description, the same is to be considered as illustrative and not restrictive in character. Only certain embodiments have been shown and described, and all changes, equivalents, and modifications that come within the spirit of the invention described herein are desired to be protected. Any experiments, experimental examples, or experimental results provided herein are intended to be illustrative of the present invention and should not be considered limiting or restrictive with regard to the invention scope. Further, any theory, mechanism of operation, proof, or finding stated herein is meant to further enhance understanding of the present invention and is not intended to limit the present invention in any way to such theory, mechanism of operation, proof, or finding. Thus, the specifics of this description and the attached drawings should not be interpreted to limit the scope of this invention to the specifics thereof. Rather, the scope of this invention should be evaluated with reference to the claims appended hereto. In reading the claims it is intended that when words such as "a", "an", "at least one", and "at least a portion" are used there is no intention to limit the claims to only one item unless specifically stated to the contrary in the claims. Further, when the language "at least a portion" and/or "a portion" is used, the claims may include a portion and/or the entire items unless specifically stated to the contrary. Finally, all publications, patents, and patent applications cited in this specification are herein incorporated by reference to the extent not inconsistent with the present disclosure as if each were specifically and individually indicated to be incorporated by reference and set forth in its entirety herein.

## Claims

1. An electrical circuit comprising:
an unsupported conductor having at least one gap formed therein; and
an electrical component having a first lead and a second lead, the first and second leads being conductively coupled to the unsupported conductor such that the electrical component bridges the gap.

2. The electrical circuit of claim 1 further comprising at least one crimp tab coupling the electrical component to the unsupported conductor.

3. The electrical circuit of claim 1 further comprising at least one fence.

4. The electrical circuit of claim 1 wherein the electrical component comprises a light emitting diode.

5. The electrical circuit of claim 1 wherein the unsupported conductor is composed of material selected from the group consisting of copper and aluminum.

6. The electrical circuit of claim 1 wherein the electrical component is selected from the group consisting of resistor, capacitor, and diode.

7. The electrical circuit of claim 6 wherein the diode is a light emitting diode.

8. An electrical circuit comprising:
an unsupported conductor having a first portion and a second portion;
an electrical component, said electrical component having a first lead and a second lead, the first lead being conductively coupled to the first portion and the second lead being conductively coupled to the second portion;
wherein the first portion and the second portion are coupled only by said at least one electrical component; and
wherein at least one electrical component forms a structural member of said unsupported conductor.

9. The electrical circuit of claim 8 further comprising at least one crimp tab coupling the electrical component to the unsupported conductor.

10. The electrical circuit of claim 8 further comprising at least one fence.

11. The electrical circuit of claim 8 wherein the electrical component comprises a light emitting diode.

12. The electrical circuit of claim 8 wherein the electrical component is selected from the group consisting of resistor, capacitor, and diode.

13. The electrical circuit of claim 12 wherein the diode is a light emitting diode.

14. A conductive device kit comprising:
at least one electrical component; and
an unsupported conductor having at least a portion adapted to be removed thereby forming a gap, the unsupported conductor configured to receive at least one electrical component across the gap thereby forming a circuit path.

15. The conductive device kit of claim 14 wherein the at least one electrical component is selected from the group consisting of resistors, capacitors, and diodes.

16. The conductive device kit of claim 15 wherein the diodes includes includes a light emitting diode.

17. The conductive device of claim 14 wherein the unsupported conductor further comprises at least one crimp tab.

18. The conductive device of claim 14 further comprising at least one fence.

19. A method of making a conductive device, the method comprising:
providing an operative piece;
shaping the operative piece into an unsupported conductor;
forming a gap in the unsupported conductor; and
placing an electrical component across the gap thereby forming a circuit path.

20. The method of making a conductive device in claim 19 wherein said shaping step is selected from the group consisting of stamping, cutting, forming, and molding.

21. The method of making a conductive device in claim 19 further comprising providing at least one crimp tab on the unsupported conductor.

22. The method of making a conductive device in claim 19 further comprising providing at least one fence on the operative piece.

23. A method of making a conductive device, the method comprising:
providing an unsupported conductor;
forming a gap in the unsupported conductor; and
placing an electrical component across the gap thereby forming a circuit path.

24. The method of making a conductive device in claim 23 further comprising providing at least one crimp tab on the unsupported conductor.

25. The method of making a conductive device in claim 23 further comprising providing at least one fence on the unsupported conductor.

26. A method of retrofitting a lighting device, the method comprising:
providing a lamp assembly;
removing an existing lighting source from the lamp assembly;
providing an unsupported conductor having electrical components forming a circuit; and
placing the unsupported conductor into the lamp assembly.

27. The method of retrofitting a lighting device in claim 26, wherein the step of providing the lamp assembly includes providing an incandescent lamp assembly.

28. The method of retrofitting a lighting device in claim 26, wherein the step of removing the existing lighting source includes removing an incandescent bulb.

29. The method of retrofitting a lighting device in claim 26, wherein said placing step comprises the steps of:
installing a cradle into the lamp assembly; and
placing the unsupported conductor into the cradle.

30. The method of retrofitting a lighting device in claim 29 wherein the unsupported conductor is adapted to be received in the cradle.

31. A wiring assembly embedded with a circuit, the assembly comprising:
an unsupported conductor having a first wire section and a second wire section with a gap therebetween;
an electrical component having a first component end and a second component end, the electrical component coupling the first and second wire sections across the gap; and
a light emitting diode operatively coupled to the unsupported conductor.

32. The wiring assembly of claim 31 further comprising at least one crimp, the at least one crimp connecting the first component end to the first wire path.

33. The wiring assembly of claim 31 wherein the first component end is soldered to the first wire section.

34. The wiring assembly of claim 31 further comprising a protector covering at least a portion of the unsupported conductor.

35. The wiring assembly of claim 34 wherein the protector is selected from the group consisting of a cable shield, shrink tubing, and over-molded protective covering.

36. A wiring assembly embedded with a circuit, the assembly comprising:
an unsupported conductor having a first wire section and a second wire section with a gap therebetween;
an electrical component having a first component end and a second component end, the electrical component coupling the first and second wire sections across the gap;
a connector operatively coupled to the first end; and
a light emitting diode selectively operatively coupled to the connector.

37. The wiring assembly of claim 36 further comprising at least one crimp, the at least one crimp connecting the first component end to the first wire path.

38. The wiring assembly of claim 36 wherein the first component end is soldered to the first wire section.

39. The wiring assembly of claim 36 further comprising a protector covering at least a portion of the unsupported conductor.

40. The wiring assembly of claim 39 wherein the protector is selected from the group consisting of a cable shield, shrink tubing, and over-molded protective covering.
